# EUROPEAN PATENT APPLICATION

(11) **EP 4 697 497 A1**
(43) Date of publication of application: **18.02.2026**
(21) Application number: 24788038.8
(22) Date of filing: 09.04.2024
(51) Int. Cl.: H01Q 1/42, H01Q 1/50

(54) **ELECTRONIC DEVICE**

(30) Priority: 14.04.2023 CN 202310405463
(71) Applicant: Vivo Mobile Communication Co., Ltd., Dongguan, Guangdong 523863 (CN)
(72) Inventor: ZHOU, Yu, Dongguan, Guangdong 523863 (CN)
(74) Representative: Lavoix
(86) International application number: PCT/CN2024/086691
(87) International publication number: WO 2024/212935

(57) **Abstract**

An electronic device includes a housing, a screen assembly, a conductive shielding cover, and a circuit board. The screen assembly is connected to the housing, the screen assembly and the housing enclose to form an accommodation cavity, and the conductive shielding cover and the circuit board are separately disposed in the accommodation cavity. A feed point is disposed on the conductive shielding cover, the feed point is electrically connected to the circuit board, and the conductive shielding cover and the circuit board enclose to form a cavity. The conductive shielding cover includes a top wall and a side wall, an opening configured to radiate a signal is provided on the side wall, and the opening is provided opposite to a non-display area of the screen assembly.

## Description

### CROSS-REFERENCE TO RELATED APPLICATIONS

This application claims priority to Chinese Patent Application No. 202310405463.5, filed on April 14, 2023 in China, which is incorporated herein by reference in its entirety.

### TECHNICAL FIELD

The present disclosure relates to the technical field of electronic products, and specifically, to an electronic device.

### BACKGROUND

With rapid development of communication technologies, functions of smart terminal devices are becoming increasingly powerful. Tablets, in particular, have shown an explosive growth in recent years. As consumer demand for smart terminal devices increases, consumers have higher requirements on terminal device consumption experience. Appearance experience and communication experience are two crucial aspects, and consumers have higher requirements on quality and a speed of communication. A multi-band/wideband communication module enables people to enjoy better communication quality and a faster communication speed in a communication process, and enables a device to be compatible with more connections to provide better user experience, so that user experience is improved. How to design a communication system with more frequency bands/wider bandwidth in a highly-integrated smart terminal device is a common pursuit in the communication field of smart terminals. To enable a terminal device to have more frequency bands and wider bandwidth, an antenna usually needs to be added to the terminal device. However, due to a limitation of internal stacking space of a terminal device, an existing terminal device usually lacks sufficient space for installing an antenna that needs to be added, making it impossible to meet a requirement of increasing frequency bands of the terminal device and widening bandwidth.

### SUMMARY

The present disclosure provides an electronic device, to increase frequency bands of the electronic device and widen bandwidth.

Embodiments of the present disclosure provide an electronic device, including a housing, a screen assembly, a conductive shielding cover, and a circuit board. The screen assembly is connected to the housing, the screen assembly and the housing enclose to form an accommodation cavity, and the conductive shielding cover and the circuit board are separately disposed in the accommodation cavity.

A feed point is disposed on the conductive shielding cover, the feed point is electrically connected to the circuit board, and the conductive shielding cover and the circuit board enclose to form a cavity.

The conductive shielding cover includes a top wall and a side wall, an opening configured to radiate a signal is provided on the side wall, and the opening is provided opposite to a non-display area of the screen assembly.

In embodiments of the present disclosure, the feed point is disposed on the conductive shielding cover, and the circuit board is electrically connected to the feed point to form a cavity antenna. Due to that an existing conductive shielding cover inside the electronic device can be reused, the cavity antenna can be added inside the electronic device without increasing antenna space. This helps increase frequency bands of the electronic device and widen bandwidth.

### BRIEF DESCRIPTION OF DRAWINGS

FIG. 1 is a schematic diagram 1 of a cross-sectional structure of an electronic device according to an embodiment of the present disclosure;
FIG. 2 is a top view of FIG. 1;
FIG. 3 is a top view 1 of a cavity antenna;
FIG. 4 is a top view 2 of a cavity antenna;
FIG. 5 is a schematic diagram 1 of an internal structure of an electronic device according to an embodiment of the present disclosure;
FIG. 6 is a top view 3 of a cavity antenna;
FIG. 7 is a schematic diagram 2 of an internal structure of an electronic device according to an embodiment of the present disclosure;
FIG. 8 is a top view 4 of a cavity antenna;
FIG. 9 is a front view of a cavity antenna;
FIG. 10 is a schematic diagram 2 of a cross-sectional structure of an electronic device according to an embodiment of the present disclosure;
FIG. 11 is a top view of FIG. 10;
FIG. 12 is a top view in which a cavity in FIG. 10 faces forward;
FIG. 13 is a schematic diagram of a projection in an opening direction of a cavity antenna;
FIG. 14 is a left view of FIG. 13; and
FIG. 15 is a curve graph of a simulation result.

### DESCRIPTION OF EMBODIMENTS

The technical solutions in embodiments of the present disclosure are described below clearly with reference to the accompanying drawings in embodiments of the present disclosure. Apparently, the described embodiments are some rather than all of embodiments of the present disclosure. All other embodiments obtained by a person of ordinary skill in the art based on embodiments of the present disclosure shall fall within the protection scope of the present disclosure.

In the specification and claims of the present disclosure, terms such as "first" and "second" are used to distinguish between similar objects, and are not used to describe a particular order or sequence. It should be understood that terms used in such a way are interchangeable in proper circumstances, so that embodiments of the present disclosure can be implemented in an order other than the order illustrated or described herein. Objects classified by "first", "second", and the like are usually of a same type, and a quantity of objects is not limited. For example, there may be one or more first objects. In addition, in the specification and claims, "and/or" indicates at least one of connected objects, and the character "/" generally indicates an "or" relationship between associated objects.

With reference to the accompanying drawings, an electronic device provided in embodiments of the present disclosure is described below in detail by using specific embodiments and application scenarios thereof.

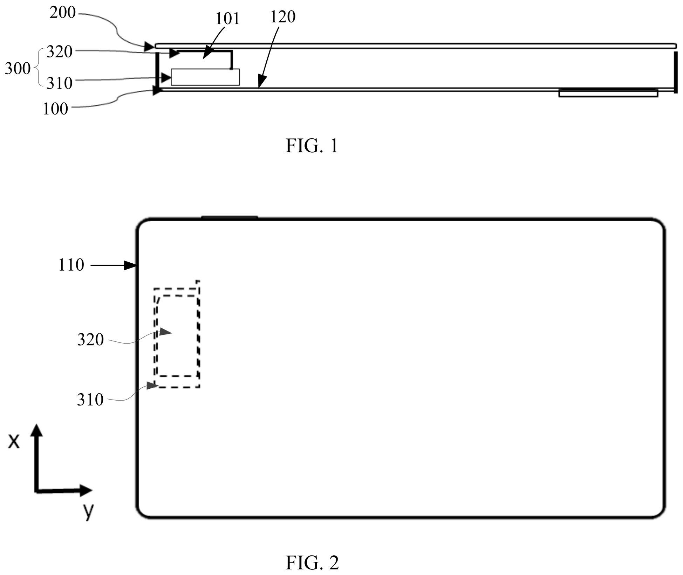

Refer to FIG. 1 to FIG. 14. FIG. 1 to FIG. 14 are structural schematic diagrams of an electronic device according to embodiments of the present disclosure. The electronic device includes a housing 100, a screen assembly 200, a conductive shielding cover 320, and a circuit board 310. The screen assembly 200 is connected to the housing 100, the screen assembly 200 and the housing 100 enclose to form an accommodation cavity 101, and the conductive shielding cover 320 and the circuit board 310 are separately disposed in the accommodation cavity 101.

A feed point 321 is disposed on the conductive shielding cover 320, the feed point 321 is electrically connected to the circuit board, and the conductive shielding cover 320 and the circuit board 310 enclose to form a cavity. The cavity formed by enclosing by the conductive shielding cover 320 and the circuit board 310 and a feed jointly form a cavity antenna.

The conductive shielding cover 320 includes a top wall 3201 and a side wall 3202, an opening 325 configured to radiate a signal is provided on the side wall 3202, and the opening 325 is provided opposite to a non-display area 210 of the screen assembly 200.

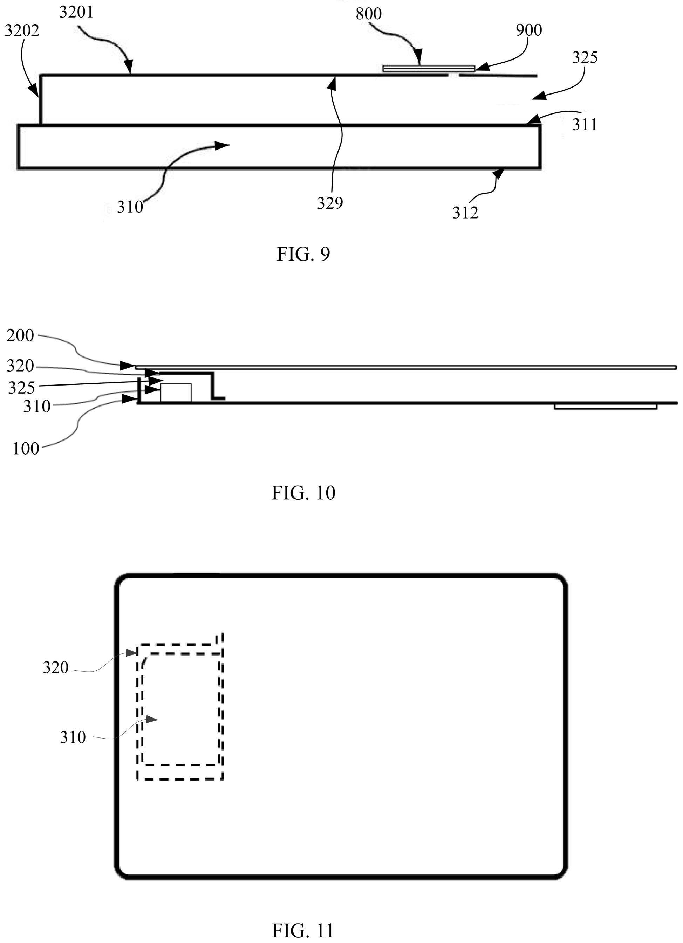

It may be understood that the conductive shielding cover 320 may form a radiator of the cavity antenna 300. Refer to FIG. 10. The conductive shielding cover 320 may include the opening 325 configured to radiate the signal. It may be understood that other end surfaces of the cavity of the cavity antenna 300 are closed.

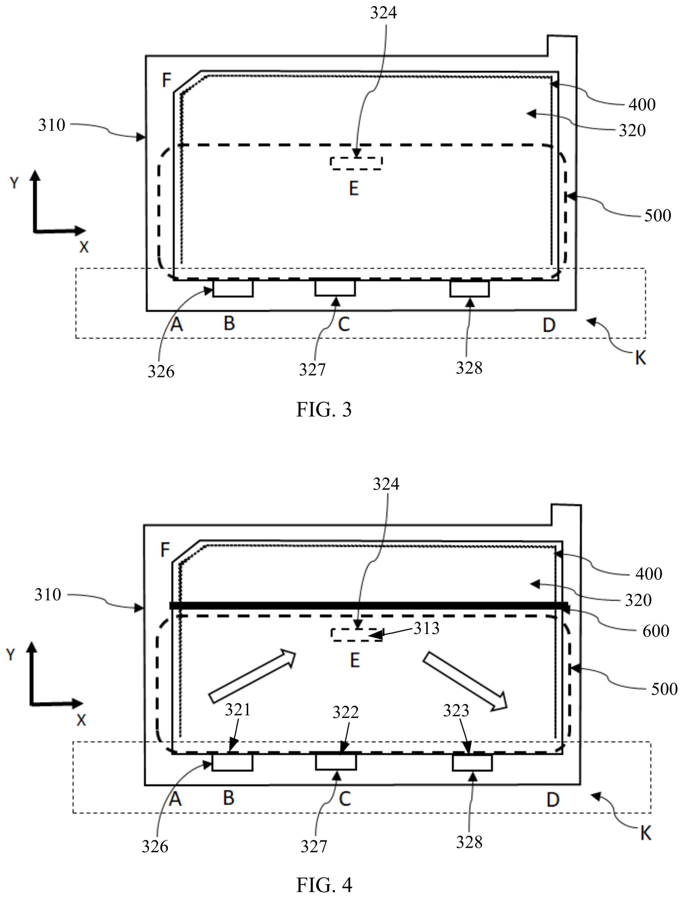

The opening 325 being provided opposite to the non-display area 210 of the screen assembly 200 may specifically mean that the opening 325 is provided facing the non-display area 210 of the screen assembly 200. In addition, the opening 325 being provided opposite to the non-display area 210 of the screen assembly 200 may alternatively mean that a radiation area corresponding to the opening 325 is disposed opposite to the non-display area 210 of the screen assembly 200. The radiation area corresponding to the opening 325 is an area, inside the electronic device, covered by the signal radiated by the cavity antenna 300 through the opening 325. For example, with reference to FIG. 4, in an embodiment of the present disclosure, a rectangular area K outside the opening 325 may form the radiation area. In other words, a range in which the opening 325 of the cavity antenna 300 performs radiation outward may be considered as the rectangular area K. In this way, the rectangular area K can be disposed opposite to the non-display area 210 of the screen assembly 200, so that the signal in the rectangular area K can be radiated outward through the non-display area 210.

The screen assembly 200 generally includes a glass cover plate and a display module that are stacked, a size of the display module is slightly smaller than that of the glass cover plate, and the glass cover plate includes a display area opposite to the display module and the non-display area 210 not opposite to the display module. The display area is an area used by the electronic device to display an image. The non-display area 210 is located on the periphery of the display area, the non-display area 210 is usually coated with ink, and the ink is mostly black, so that a black border area is formed at an edge of the screen assembly 200. Therefore, the non-display area 210 may be the black border area located at the edge of the screen assembly 200. The opening 325 is provided opposite to the non-display area 210 of the screen assembly 200, so that the cavity antenna 300 can perform radiation outward through the black border area of the screen assembly 200, to improve signal radiation effect of the cavity antenna 300.

An existing circuit board 310 in the electronic device may be reused as the foregoing circuit board 310. In addition, the circuit board 310 may alternatively be a printed circuit board (Printed Circuit Board, PCB) newly added in the electronic device. The circuit board 310 may include a feed circuit, and the feed point 321 is electrically connected to the feed circuit of the circuit board, so that the feed circuit can feed a feed signal into the feed point 321.

The electronic device may be various smart terminal devices in a scenario in a related technology. For example, the electronic device may be a mobile phone, a tablet, or a notebook computer.

In this implementation, the feed point 321 is disposed on the conductive shielding cover 320, and the circuit board 310 is electrically connected to the feed point 321 to form the cavity antenna 300. Due to that an existing conductive shielding cover 320 inside the electronic device can be reused, the cavity antenna 300 can be added inside the electronic device without increasing antenna space. This helps increase frequency bands of the electronic device and widen bandwidth.

Optionally, a first tuning point 322 is further disposed on the conductive shielding cover 320, the circuit board 310 includes a first tuning circuit, and the first tuning point 322 is grounded through the first tuning circuit.

The top wall 3201 includes a first surface 329 disposed opposite to the circuit board 310, an edge length size of the first surface 329 matches a wavelength of a first frequency band, the first tuning point 322 is located on a first edge of the first surface 329, a distance between the first tuning point 322 and an end of the first edge matches a wavelength of a second frequency band, and the second frequency band is different from the first frequency band.

In a case that a feed signal of the first frequency band is fed into the feed point 321, the first tuning circuit is in a disconnected state.

In a case that a feed signal of the second frequency band is fed into the feed point 321, the first tuning circuit is in a connected state.

The first frequency band and the second frequency band may be any two of a low frequency band, a mid frequency band, and a high frequency band. Alternatively, one of the first frequency band and the second frequency band is a low frequency band and the other one is a mid and high frequency band. Alternatively, the first frequency band may be a part of frequency band in a low frequency band, and the second frequency band may be a part of frequency band in a high frequency band. For example, in an embodiment of the present disclosure, the first frequency band may include a Wi-Fi 2.4G frequency band, and the second frequency band may include a Wi-Fi 5G frequency band and a Wi-Fi 6E frequency band. In this way, only one cavity antenna 300 needs to be disposed in the electronic device to implement full coverage of the Wi-Fi 2.4G frequency band, the Wi-Fi 5G frequency band, and the Wi-Fi 6E frequency band.

It may be understood that, in different working modes, the feed circuit in the circuit board 310 may feed, into the feed point 321, feed signals of different frequency bands.

The first edge may be one edge of the opening 325. The edge length size of the first surface 329 matching the wavelength of the first frequency band may mean that a size of a part of edges of the first surface 329 matches the wavelength of the first frequency band. For example, an edge length of one edge of the first surface 329 is one-fourth of the wavelength of the first frequency band, or an edge length of one edge of the first surface 329 is one-half of the wavelength of the first frequency band, or the like. In addition, the edge length size of the first surface 329 matching the wavelength of the first frequency band may mean that a size of each edge of the first surface 329 matches the wavelength of the first frequency band. For example, an edge length of each edge of the first surface 329 is one-fourth of the wavelength of the first frequency band, or an edge length of each edge of the first surface 329 is one-half of the wavelength of the first frequency band, or the like. Alternatively, an edge length of a part of the edges of the first surface 329 is one-fourth of the wavelength of the first frequency band, and an edge length of another part of the edges is one-half of the wavelength of the first frequency band. This can ensure that a basic mode of the cavity antenna 300 can cover the first frequency band.

Correspondingly, the distance between the first tuning point 322 and the end of the first edge matching the wavelength of the second frequency band may mean that the distance between the first tuning point 322 and the end of the first edge is one-half of the wavelength of the second frequency band, or the distance between the first tuning point 322 and the end of the first edge is one-fourth of the wavelength of the second frequency band. This can ensure that the basic mode of the cavity antenna 300 can cover the second frequency band.

The wavelength of the first frequency band may be an equivalent medium wavelength of the first frequency band, and correspondingly, the wavelength of the second frequency band may be an equivalent medium wavelength of the second frequency band.

The first tuning circuit may be a common tuning circuit in a related technology, for example, may be an LC tuning circuit formed by a combination of a capacitor and an inductor. Specifically, when the first frequency band is a low frequency band and the second frequency band is a high frequency band, the first tuning circuit may include a capacitor. Due to that the capacitor has a characteristic of passing a high frequency and blocking a low frequency, the following functions may be implemented: In a case that the feed signal of the first frequency band is fed into the feed point 321, the first tuning circuit is in the disconnected state; and in a case that the feed signal of the second frequency band is fed into the feed point 321, the first tuning circuit is in the connected state. It may be understood that, in addition to the capacitor, the first tuning circuit may further include another tuning component, for example, may include another inductor or capacitor.

The first edge may form one edge of the opening 325. In addition, the first edge may alternatively be a common edge of the first surface 329 and a side surface on which the opening 325 is located.

In this implementation, due to that the edge length size of the first surface 329 of the conductive shielding cover 320 matches the wavelength of the first frequency band, the basic mode of the cavity antenna 300 can implement radiation of a signal of the first frequency band. Due to that the first tuning circuit is in the connected state in a case that the feed signal of the second frequency band is fed into the feed point 321, the first tuning point 322 forms a strong-current grounding structure when the feed signal of the second frequency band is fed into the feed point 321, and due to that the distance between the first tuning point 322 and the end of the first edge matches the wavelength of the second frequency band, the cavity antenna 300 can further implement radiation of a signal of the second frequency band. In addition, due to that the first tuning circuit is in the disconnected state in a case that the feed signal of the first frequency band is fed into the feed point 321, introduction of the first tuning point 322 does not affect the basic mode of the cavity antenna 300. In this way, the cavity antenna 300 can simultaneously cover the first frequency band and the second frequency band. This helps increase frequency bands of the electronic device and widen bandwidth.

Optionally, the second frequency band includes a first sub-frequency band and a second sub-frequency band, a distance between the first tuning point 322 and a first endpoint of the first edge is one-half of a wavelength of the first sub-frequency band, and a distance between the first tuning point 322 and a second endpoint of the first edge is one-half of a wavelength of the second sub-frequency band.

It may be understood that the first frequency band, the first sub-frequency band, and the second sub-frequency band are three different frequency bands. For example, the first frequency band is the Wi-Fi 2.4G frequency band, the first sub-frequency band is the Wi-Fi 5G frequency band, and the second sub-frequency band is the Wi-Fi 6E frequency band. Alternatively, the first frequency band may be the Wi-Fi 2.4G frequency band, the first sub-frequency band is a Wi-Fi 5.1G frequency band in the Wi-Fi 5G frequency band, and the second sub-frequency band is a Wi-Fi 5.8G frequency band in the Wi-Fi 6E frequency band. For ease of understanding, an example in which the first frequency band may be the Wi-Fi 2.4G frequency band, the first sub-frequency band is the Wi-Fi 5.1G frequency band, and the second sub-frequency band is the Wi-Fi 5.8G frequency band is used below to further describe the electronic device provided in embodiments of the present disclosure.

In this implementation, due to that the distance between the first tuning point 322 and the first endpoint of the first edge is one-half of the wavelength of the first sub-frequency band, in a case that a feed signal of the first sub-frequency band is fed into the feed point 321, an area between the first tuning point 322 on the first edge and the first endpoint of the first edge may be used for signal radiation, to cover a signal of the first sub-frequency band. Correspondingly, due to that the distance between the first tuning point 322 and the second endpoint of the first edge is one-half of the wavelength of the second sub-frequency band, in a case that a feed signal of the second sub-frequency band is fed into the feed point 321, an area between the first tuning point 322 on the first edge and the second endpoint of the first edge may be used for signal radiation, to cover a signal of the second sub-frequency band. In this way, the cavity antenna 300 can simultaneously cover the first frequency band, the first sub-frequency band, and the second sub-frequency band. This helps increase frequency bands of the electronic device and widen bandwidth.

Optionally, the first surface 329 is a rectangular surface, the first surface 329 further includes a second edge adjacent to the first edge, a length of the first edge is one-half of the wavelength of the first frequency band, and a length of the second edge is one-fourth of the wavelength of the first frequency band.

Specifically, with reference to FIG. 4, in an embodiment of the present disclosure, an edge AD of the first surface 329 is the first edge, an edge AF of the first surface 329 is the second edge, a location point B on the first edge forms the feed point 321, a location point C on the first edge forms the feed point 321, a location point A on the first edge forms the first endpoint of the first edge, and a location point D on the first edge forms the second endpoint of the first edge. In FIG. 4, AD in a direction x is a length of the cavity of the cavity antenna 300, and AF in a direction y is a width of the cavity. Due to that AD is approximately λ/2 of the Wi-Fi 2.4G frequency band, a λ/2 lateral mode in the direction x can be formed, and due to that AF is approximately λ/4 of the Wi-Fi 2.4G frequency band, a λ/4 longitudinal mode (λ is an equivalent medium wavelength of the frequency band) in the direction x can be formed, to form a basic mode TE1, 1/2 of the cavity antenna 300. The basic mode can cover the Wi-Fi 2.4G frequency band.

In a case that a design of the cavity antenna 300 includes only the feed point 321 but does not include the first tuning point 322, when the cavity antenna 300 operates on the Wi-Fi 5G and Wi-Fi 6E frequency bands, a 3/2λ high-order mode is easily formed on AD, and a 3/4λ high-order mode is easily formed on AF. As a result, efficiency pits are formed in the band, affecting antenna efficiency and bandwidth. In the present disclosure, a feature that a feed tuning location can be flexibly added in the circuit board 310 is used, to introduce the first tuning point 322, so as to construct an ultra-wideband mode of Wi-Fi 5G/6E. Specifically, the first tuning point 322 is added in the direction x of the cavity opening surface, and the first tuning point 322 is electrically connected to the first tuning circuit, so that a strong-current grounding structure can be formed for the Wi-Fi 5G and Wi-Fi 6E frequency bands, to control modes of the Wi-Fi 5G and Wi-Fi 6E frequency bands in the direction x of the opening surface. AC may form a λ/2 mode of Wi-Fi 5.8G, and CD may form a λ/2 mode of Wi-Fi 5.1G. Mode switching can be implemented by appropriately adjusting the location of the first tuning point 322. In other words, AC forms the λ/2 mode of Wi-Fi 5.1G, and CD forms the λ/2 mode of Wi-Fi 5.8G. The first tuning point 322 presents small capacitance for 2.4G, and aperture adjustment may be performed. The first tuning point 322 is introduced, so that the cavity antenna 300 can well cover the Wi-Fi 2.4G/Wi-Fi 5.1G/Wi-Fi 5.8G frequency band in terms of mode.

Optionally, at least one second tuning point 324 is further disposed on the conductive shielding cover 320, the at least one second tuning point 324 is located in a middle area of the first surface 329, the circuit board 310 further includes at least one second tuning circuit that is in a one-to-one correspondence with the at least one second tuning point 324, and each second tuning point 324 is grounded through the corresponding second tuning circuit.

In a case that the feed signal of the first frequency band is fed into the feed point 321, the at least one second tuning circuit is in a disconnected state.

In a case that the feed signal of the second frequency band is fed into the feed point 321, the at least one second tuning circuit is in a connected state, and the cavity forms a quarter-wavelength mode in a direction of a second edge, where the second edge is an edge, adjacent to the first edge, of the first surface 329. In addition, an electrical wall 600 is formed in the cavity antenna 300, the electrical wall 600 divides the cavity antenna 300 into two different cavities, and the at least one second tuning point 324 is located on a side, facing the opening 325, of the electrical wall 600.

The first surface 329 may be a rectangular surface, and the middle area of the first surface 329 may be an intersection area of two diagonal lines of the first surface 329, or the middle area of the first surface 329 may be an area in which an axis of symmetry of the first surface 329 is located. As shown in FIG. 3, the second edge may be an edge AF.

The second tuning circuit may be a common tuning circuit in a related technology, for example, may be an LC tuning circuit formed by a combination of a capacitor and an inductor. Specifically, when the first frequency band is a low frequency band and the second frequency band is a high frequency band, the second tuning circuit may include a capacitor. Due to that the capacitor has a characteristic of passing a high frequency and blocking a low frequency, the following functions may be implemented: In a case that the feed signal of the first frequency band is fed into the feed point 321, the second tuning circuit is in the disconnected state; and in a case that the feed signal of the second frequency band is fed into the feed point 321, the second tuning circuit is in the connected state. It may be understood that, in addition to the capacitor, the second tuning circuit may further include another tuning component, for example, may include another inductor or capacitor.

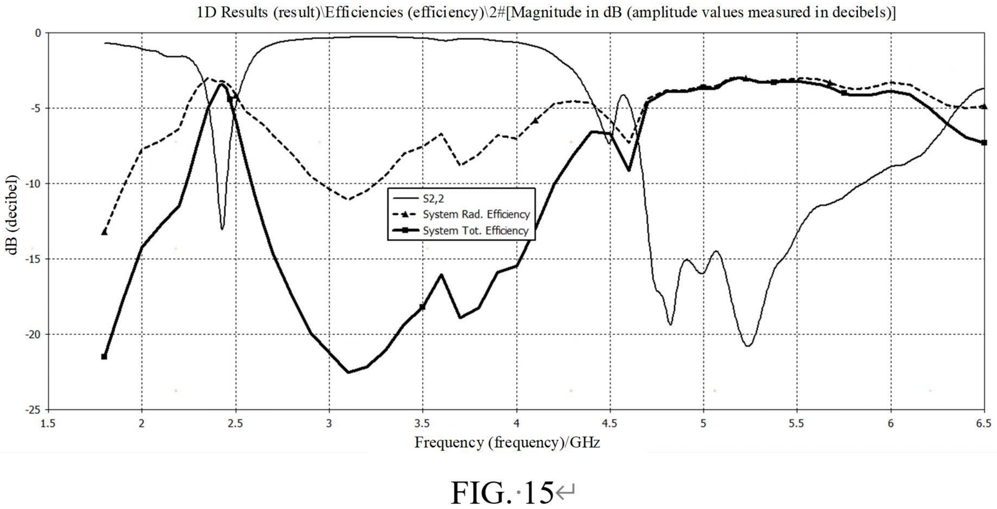

In this embodiment of the present disclosure, the second tuning point 324 is introduced, so that a boundary condition of Wi-Fi 5G and Wi-Fi 6E of the original cavity of the cavity antenna 300 can be changed. Specifically, a λ/4 mode in the direction y may be formed, and a traveling wave mode shown by a hollow arrow in FIG. 4 may be formed. The second tuning point 324 is located at a location of a point E in FIG. 4. Specifically, before the second tuning point 324 is introduced, an area in which the point E is located is a strong electric field area (not necessarily a strongest electric field area) of Wi-Fi 5G/Wi-Fi 6E. After the second tuning point 324 is introduced, the second tuning point 324 may be used as an LC circuit or a small capacitor with a low resistance value, to form a λ/4 mode in the direction y (longitudinal direction). In addition, a short-circuit point is approximately formed for Wi-Fi 5G/Wi-Fi 6E in the direction x in which the point E is located, to achieve effect similar to that of the electrical wall 600 in FIG. 4. In this way, the electrical wall 600 may be used to reflect a signal in a direction indicated by the hollow arrow, to form a traveling wave mode similar to a waveguide, and obtain a high-frequency ultra-wideband effect diagram shown in FIG. 15. In addition, the second tuning point 324 is approximately open-circuited or presents small capacitance for Wi-Fi 2.4G, and for Wi-Fi 2.4G, entire space of the cavity may still be used for resonance. For a low frequency, space is not wasted. One second tuning point 324 may be disposed only at a center location of x and y inside the cavity. Alternatively, two or more second tuning points 324 may be disposed near a y-direction centerline.

Refer to FIG. 4. Due to that the electrical wall 600 is formed in the cavity antenna 300, when an operating frequency band of the cavity antenna 300 is the second frequency band, the cavity of the cavity antenna 300 may be equivalent to a sub-cavity 500 shown by a dashed line box inside the cavity antenna 300. In other words, the electrical wall 600 can reduce a size of a cavity that is actually in a working state inside the cavity antenna 300. When the operating frequency band of the cavity antenna 300 is the first frequency band, an entire cavity inside the cavity antenna 300 is used as the cavity of the cavity antenna 300.

In this implementation, for mode construction, Wi-Fi 2.4G is implemented by using a conventional basic mode, which is a resonant mode. For a mode of Wi-Fi 5G and Wi-Fi 6E, a tuning point inside the cavity is used, to implement low-impedance grounding tuning for Wi-Fi 5G and Wi-Fi 6E, and change a boundary condition of the original cavity. An extremely-narrow cavity design is formed, to construct a traveling wave mode for Wi-Fi 5G and Wi-Fi 6E. In terms of process implementation, the circuit board 310 may be a common double-sided through-hole board, a material is a common PP+glass fiber sheet, a processing process is mature, and a type selection threshold is low. The through-hole double-sided board has a simple production process, sample delivery is quick, and efficiency is high. The conductive shielding cover 320 and the circuit board 310 may be welded in an SMT manner, a process is mature, quality is stable, a yield is high, and processing precision is fine (within 0.02 mm), which facilitates stability and consistency of antenna performance. After an overall module is completed, it is easy to assemble and fasten the module inside the entire device. This reduces costs, and can improve a yield and improve coverage effect and consistency of antenna performance.

The foregoing implementations are applied to an actual entire device, and with reference to internal architecture distribution of the entire device and a location of the circuit board 310, structures such as the conductive shielding cover 320, the circuit board 310, the feed point 321, the first tuning point 322, and the second tuning point 324 are correspondingly preset, and Wi-Fi full frequency band simulation is performed. FIG. 15 is a schematic diagram of a simulation result. It can be learned from FIG. 15 that, in the cavity antenna 300 inside the electronic device in embodiments of the present disclosure, a mode for a low frequency is a basic mode, that is, a resonant mode, and covers Wi-Fi 2.4G, and a mode for a high frequency is similar to a traveling wave mode, and covers Wi-Fi 5G and Wi-Fi 6E, so that a requirement for full frequency band is met.

Optionally, the opening 325 is opposite to a first side wall 110 of the housing 100, and an area, opposite to the housing, of the first side wall 110 is a non-metallic area.

An area other than the non-metallic area of the housing 100 may be made of a metal material. The non-metallic area may be made of various non-metallic materials used for manufacturing a housing of an electronic device in a related technology. For example, a material of the non-metallic area may be a plastic material.

In this implementation, due to that a first target area opposite to the opening 325 is a non-metallic area, a signal radiated from the opening 325 may penetrate the first target area and be radiated to the outside of the electronic device. In this way, the electronic device can radiate signals outward simultaneously through the non-display area 210 of the screen assembly 200 and the non-metallic area, to help improve signal radiation effect of the electronic device.

In another embodiment of the present disclosure, the non-metallic area may alternatively be a metallic area. In this case, the housing 100 is made of an all-metal material. This helps improve overall appearance consistency of the electronic device.

Optionally, the circuit board 310 includes a second surface 311 and a third surface 312 that face away from each other, the second surface 311 is disposed opposite to the first surface 329, the conductive shielding cover 320 is located on a side of the second surface 311, the third surface 312 is attached to the housing 100, and the conductive shielding cover 320 is electrically connected to the housing 100 through a via in the circuit board 310.

The third surface 312 of the circuit board 310 may be in fixed connection to an inner wall of the housing 100.

In this implementation, the conductive shielding cover 320 is electrically connected to the housing 100 through the via in the circuit board 310. In this case, a height of the cavity antenna 300 is a sum of a height of the conductive shielding cover 320 and a height of the circuit board 310. This helps increase an antenna height of the cavity antenna 300, and increase a cavity volume of the cavity antenna 300, thereby helping improve antenna performance of the cavity antenna 300.

Optionally, the electronic device further includes a battery assembly 700, the battery assembly 700 is disposed in the accommodation cavity 101, a gap is formed between the battery assembly 700 and the first side wall 110 of the housing 100, the conductive shielding cover 320 and the circuit board 310 are separately disposed in the gap, and the opening 325 of the conductive shielding cover 320 faces the first side wall 110.

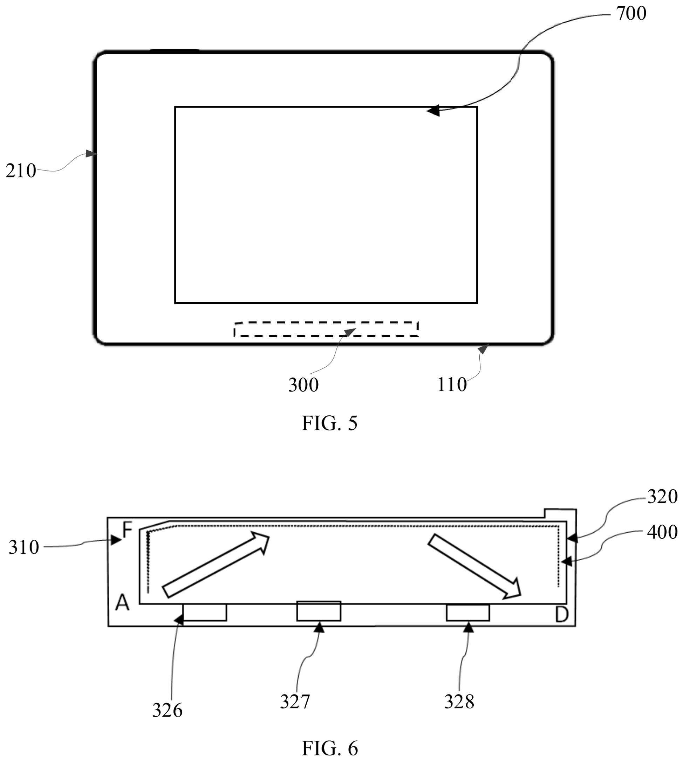

Specifically, with reference to FIG. 6, in an embodiment of the present disclosure, a length relationship between the first edge AD and the second edge AF of the first surface 329 is 2*AE≤AD≤4*AE. This can ensure that a length of AF is approximately λ/4 of the Wi-Fi 5G/Wi-Fi 6E frequency band.

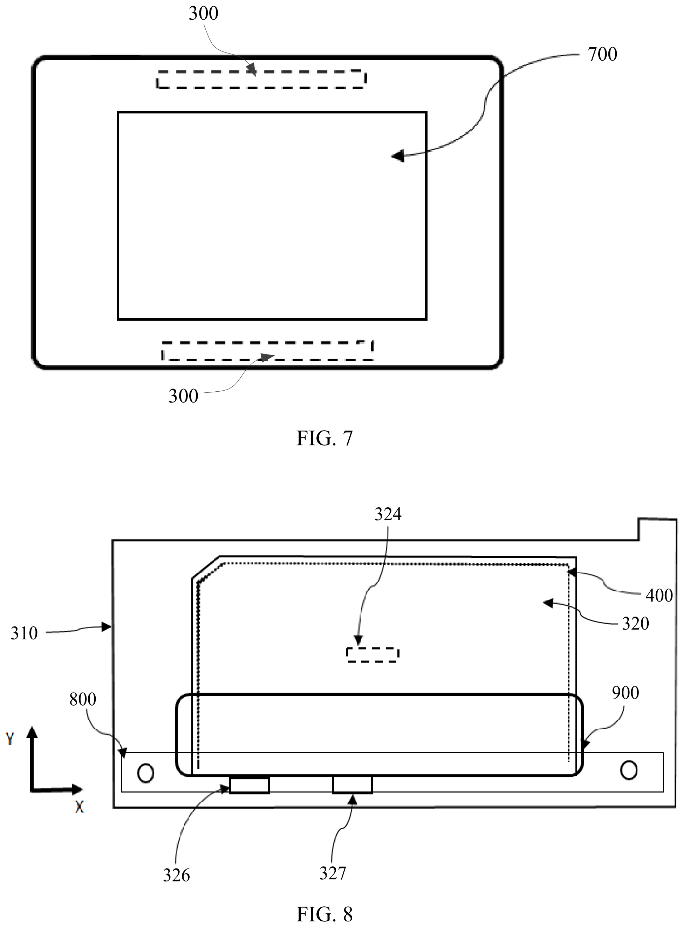

Refer to FIG. 5. In an embodiment of the present disclosure, the cavity antenna 300 may be disposed on only one side of the battery assembly 700. Refer to FIG. 7. In another embodiment of the present disclosure, one cavity antenna 300 may be disposed on each side of the battery assembly 700.

The first side wall 110 may be any side wall of two sides of the electronic device when the electronic device is in a portrait state.

In this implementation, the conductive shielding cover 320 and the circuit board 310 are separately disposed in the gap, so that the cavity antenna 300 can be disposed in the gap formed between the battery assembly 700 and the side wall of the housing 100, to effectively utilize space inside the electronic device.

Optionally, the conductive shielding cover 320 is electrically connected to a fourth surface 120 of the housing 100, the circuit board 310 is accommodated inside the conductive shielding cover 320, and the fourth surface 120 is a surface, facing the screen assembly 200, of the housing.

Specifically, a screw or laser welding manner may be used to implement lamination of the conductive shielding cover 320 and the housing 100, or a peripheral plastic member may be used to implement lamination of the conductive shielding cover 320 and the housing 100.

In this implementation, the conductive shielding cover 320 is directly in fixed connection to the fourth surface 120 of the housing 100, and the circuit board 310 is located inside the conductive shielding cover 320. In comparison with the foregoing embodiment, this helps improve reliability of an overall structure of the cavity antenna 300.

Optionally, a gap at a connection between the conductive shielding cover 320 and the housing 100 is filled with conductive foam.

In this implementation, the gap at the connection between the conductive shielding cover 320 and the housing 100 is filled with the conductive foam. This helps further improve sealing performance of the cavity of the cavity antenna 300.

Optionally, the conductive shielding cover 320 further includes a first extension part 326 and a second extension part 327. The first extension part 326 is a strip-shaped conductive part that extends toward the circuit board 310 with the feed point 321 as a start point. The second extension part 327 is a strip-shaped conductive part that extends toward the circuit board 310 with the first tuning point 322 as a start point.

The feed point 321 is electrically connected to the feed circuit through the first extension part 326, and the first tuning point 322 is electrically connected to the first tuning circuit through the second extension part 327.

Refer to FIG. 3, FIG. 13, and FIG. 14. The first extension part 326 and the second extension part 327 each may be a metal strip extending from the conductive shielding cover 320 toward the circuit board 310. In this way, the first extension part 326 can extend to a terminal at an output of the feed circuit, and the first extension part 326 can be welded to the terminal at the output of the feed circuit, to implement electrical connection between the feed circuit and the feed point 321. Correspondingly, the second extension part 327 can extend to a terminal at one end of the first feed circuit, the second extension part 327 can be welded to the terminal at the end of the first feed circuit, and the other end of the first feed circuit is grounded.

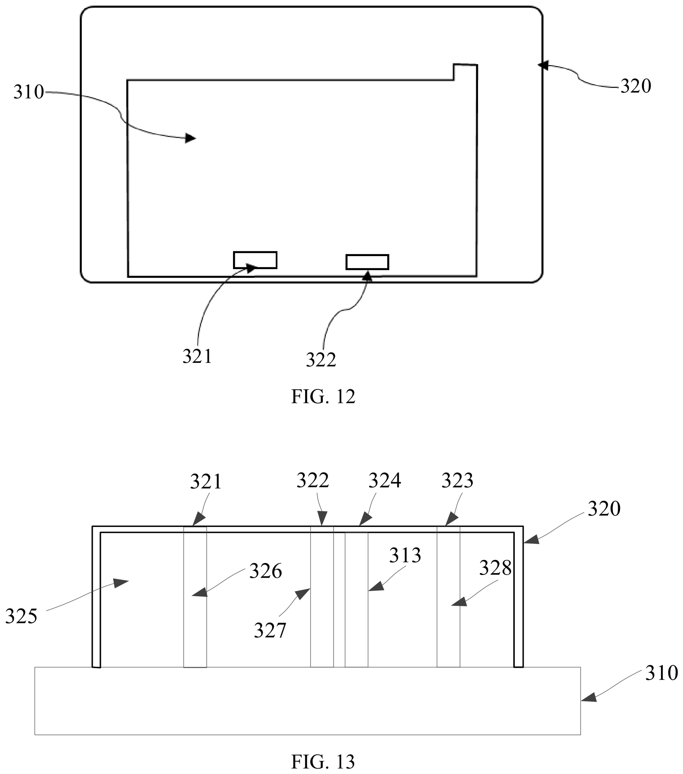

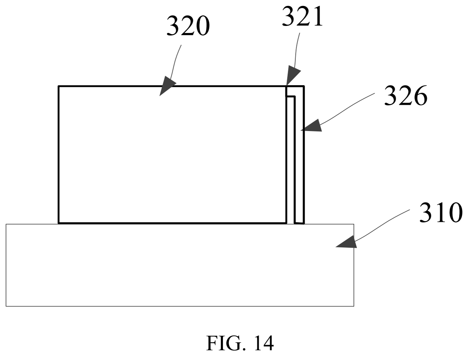

Refer to FIG. 13 and FIG. 14. In an embodiment of the present disclosure, the conductive shielding cover 320 may further include a fourth extension part 313. The fourth extension part 313 is a strip-shaped conductive part that extends toward the circuit board 310 with the second tuning point 324 as a start point. The second tuning point 324 is electrically connected to the second tuning circuit through the fourth extension part 313.

Optionally, a support point 323 is further disposed on the conductive shielding cover 320, the feed point 321, the first tuning circuit, and the support point 323 are spaced apart along the first edge, the conductive shielding cover 320 further includes a third extension part 328, and the third extension part 328 extends to the circuit board 310 with the support point 323 as a start point.

In this implementation, the third extension part 328 is further disposed, so that the first extension part 326, the second extension part 327, the third extension part 328, and the fourth extension part 313 can separately support different locations on the conductive shielding cover 320. This helps improve reliability of an overall structure of the cavity antenna 300.

Optionally, the feed circuit includes a first conductive spring plate, the first tuning circuit includes a second conductive spring plate, the feed circuit is electrically connected to the feed point 321 through the first conductive spring plate, and the first tuning circuit is electrically connected to the first tuning point 322 through the second conductive spring plate.

Specifically, in the foregoing embodiment, metal strips on the conductive shielding cover 320 generally need to be bent to form the first extension part 326, the second extension part 327, the third extension part 328, and the fourth extension part 313. As a result, certain stress exists at a connection between the extension part and the first surface 329 of the conductive shielding cover 320, and further, stability of electrical connection between the extension part and a corresponding terminal may be lowered. Based on this, in another embodiment of the present disclosure, setting of the extension part is canceled, and a conductive spring plate on the circuit board 310 is electrically connected to a corresponding location point on the conductive shielding cover 320. This helps improve stability of electrical connection between components in the cavity antenna 300.

It may be understood that the first conductive spring plate may be a spring plate, on the circuit board 310, that protrudes toward the first surface 329 of the conductive shielding cover 320, and the first conductive spring plate may be in direct contact with the feed point 321, to implement electrical connection between the feed circuit and the feed point 321. Correspondingly, the second conductive spring plate may be a spring plate, on the circuit board 310, that protrudes toward the first surface 329 of the conductive shielding cover 320, and the second conductive spring plate may be in direct contact with the first tuning point 322, to implement electrical connection between the first tuning circuit and the first tuning point 322.

In addition, the second tuning circuit may further include a third conductive spring plate. The third conductive spring plate may be a spring plate, on the circuit board 310, that protrudes toward the first surface 329 of the conductive shielding cover 320, and the third conductive spring plate may be in direct contact with the second tuning point 324, to implement electrical connection between the second tuning circuit and the second tuning point 324.

Optionally, the electronic device further includes a metal plate 800 and conductive foil 900, the metal plate 800 is attached to the conductive shielding cover 320, the metal plate 800 covers locations of the feed point 321 and the first tuning point 322, the metal plate 800 is in fixed connection to the conductive shielding cover 320, and the conductive foil 900 is disposed between the metal plate 800 and the conductive shielding cover 320.

The conductive foil 900 may be various types of metal foil, for example, may be copper foil, tin foil, or the like.

Specifically, due to that a material of the conductive shielding cover 320 is usually relatively soft, the conductive shielding cover 320 may be deformed under a pushing action of the spring plate on the circuit board 310. This may further cause a problem of poor stability of electrical connection between the spring plate on the circuit board 310 and the corresponding point on the conductive shielding cover 320.

Refer to FIG. 8 and FIG. 9. In an embodiment of the present disclosure, the metal plate 800 and the conductive foil 900 may be located on a side, facing away from the circuit board 310, of the conductive shielding cover 320. Due to that the metal plate 800 can strengthen structures at the locations of the feed point 321 and the first tuning point 322, deformation of an area covered by the metal plate 800 caused by pushing of the spring plate on the circuit board 310 can be avoided, so that stability of electrical connection between the spring plate on the circuit board 310 and the corresponding point on the conductive shielding cover 320 can be improved.

In addition, in another embodiment of the present disclosure, the metal plate 800 and the conductive foil 900 may alternatively be located between the first surface 329 of the conductive shielding cover 320 and the circuit board 310. In this case, the spring plate on the circuit board 310 may be electrically connected to the corresponding point on the conductive shielding cover 320 sequentially through the metal plate 800 and the conductive foil 900. It may be understood that the metal plate 800 may include a first annular insulation area, a second annular insulation area, and a third annular insulation area. An internal conductive area of the first annular insulation area is opposite to the feed point 321, an internal conductive area of the second annular insulation area is opposite to the first tuning point 322, and an internal conductive area of the third annular insulation area is opposite to the second tuning point 324. This can implement relative isolation between the spring plate on the circuit board 310 and a point other than the corresponding point.

In this implementation, the metal plate 800 is connected to the conductive shielding cover 320, so that a structure of the conductive shielding cover 320 can be strengthened, to improve stability of electrical connection between components inside the cavity antenna 300. In addition, a gap between the metal plate 800 and the conductive shielding cover 320 is filled with the conductive foil 900, so that sealing performance of the cavity can be further improved.

It should be noted that, in the specification, the term "include", "comprise", or any other variant thereof is intended to cover a non-exclusive inclusion, so that a process, a method, an article, or an apparatus that includes a list of elements not only includes those elements but also includes other elements which are not expressly listed, or further includes elements inherent to this process, method, article, or apparatus. In absence of more constraints, an element preceded by "includes a..." does not preclude the existence of other identical elements in the process, method, article, or apparatus that includes the element. In addition, it should be noted that the scope of the method and the apparatus in the implementations of the present disclosure is not limited to performing functions in an illustrated or discussed sequence, and may further include performing functions in a basically simultaneous manner or in a reverse sequence according to the functions concerned. For example, the described method may be performed in an order different from that described, and steps may be added, omitted, or combined. In addition, features described with reference to some examples may be combined in other examples.

Embodiments of the present disclosure are described above with reference to the accompanying drawings, but the present disclosure is not limited to the foregoing specific implementations. The foregoing specific implementations are merely examples instead of limitations. Under enlightenment of the present disclosure, a person of ordinary skill in the art may make many forms without departing from the aims of the present disclosure and the protection scope of the claims, all of which fall within the protection of the present disclosure.

## Claims

1. An electronic device, comprising a housing, a screen assembly, a conductive shielding cover, and a circuit board, wherein the screen assembly is connected to the housing, the screen assembly and the housing enclose to form an accommodation cavity, and the conductive shielding cover and the circuit board are separately disposed in the accommodation cavity;
a feed point is disposed on the conductive shielding cover, the feed point is electrically connected to the circuit board, and the conductive shielding cover and the circuit board enclose to form a cavity; and
the conductive shielding cover comprises a top wall and a side wall, an opening configured to radiate a signal is provided on the side wall, and the opening is provided opposite to a non-display area of the screen assembly.

2. The electronic device according to claim 1, wherein a first tuning point is further disposed on the conductive shielding cover, the circuit board comprises a first tuning circuit, and the first tuning point is grounded through the first tuning circuit;
the top wall comprises a first surface disposed opposite to the circuit board, an edge length size of the first surface matches a wavelength of a first frequency band, the first tuning point is located on a first edge of the first surface, a distance between the first tuning point and an end of the first edge matches a wavelength of a second frequency band, and the second frequency band is different from the first frequency band;
in a case that a feed signal of the first frequency band is fed into the feed point, the first tuning circuit is in a disconnected state; and
in a case that a feed signal of the second frequency band is fed into the feed point, the first tuning circuit is in a connected state.

3. The electronic device according to claim 2, wherein the second frequency band comprises a first sub-frequency band and a second sub-frequency band, a distance between the first tuning point and a first endpoint of the first edge is one-half of a wavelength of the first sub-frequency band, and a distance between the first tuning point and a second endpoint of the first edge is one-half of a wavelength of the second sub-frequency band.

4. The electronic device according to claim 3, wherein the first surface is a rectangular surface, the first surface further comprises a second edge adjacent to the first edge, a length of the first edge is one-half of the wavelength of the first frequency band, and a length of the second edge is one-fourth of the wavelength of the first frequency band.

5. The electronic device according to claim 3, wherein at least one second tuning point is further disposed on the conductive shielding cover, the at least one second tuning point is located in a middle area of the first surface, the circuit board further comprises at least one second tuning circuit that is in a one-to-one correspondence with the at least one second tuning point, and each second tuning point is grounded through the corresponding second tuning circuit;
in a case that the feed signal of the first frequency band is fed into the feed point, the at least one second tuning circuit is in a disconnected state; and
in a case that the feed signal of the second frequency band is fed into the feed point, the at least one second tuning circuit is in a connected state, and the cavity forms a quarter-wavelength mode in a direction of a second edge, wherein the second edge is an edge, adjacent to the first edge, of the first surface.

6. The electronic device according to claim 3, wherein the opening is opposite to a first side wall of the housing, and an area, opposite to the housing, of the first side wall is a non-metallic area.

7. The electronic device according to any one of claims 2 to 6, wherein the circuit board comprises a second surface and a third surface that face away from each other, the second surface is disposed opposite to the first surface, and the conductive shielding cover is located on a side of the second surface.

8. The electronic device according to any one of claims 2 to 6, wherein the electronic device further comprises a battery assembly, the battery assembly is disposed in the accommodation cavity, a gap is formed between the battery assembly and the first side wall of the housing, the conductive shielding cover and the circuit board are separately disposed in the gap, and an opening on the first surface faces the first side wall.

9. The electronic device according to any one of claims 2 to 6, wherein the conductive shielding cover is electrically connected to a fourth surface of the housing, the circuit board is accommodated inside the conductive shielding cover, and the fourth surface is a surface, facing the screen assembly, of the housing.

10. The electronic device according to any one of claims 2 to 6, wherein the circuit board further comprises a feed circuit, the conductive shielding cover further comprises a first extension part and a second extension part, the feed point is electrically connected to the feed circuit through the first extension part, and the first tuning point is electrically connected to the first tuning circuit through the second extension part.

11. The electronic device according to claim 10, wherein the feed circuit comprises a first conductive spring plate, the first tuning circuit comprises a second conductive spring plate, the feed circuit is electrically connected to the feed point through the first conductive spring plate, and the first tuning circuit is electrically connected to the first tuning point through the second conductive spring plate.

12. The electronic device according to claim 11, wherein the electronic device further comprises a metal plate and conductive foil, the metal plate is attached to the conductive shielding cover, the metal plate covers locations of the feed point and the first tuning point, the metal plate is in fixed connection to the conductive shielding cover, and the conductive foil is disposed between the metal plate and the conductive shielding cover.

13. The electronic device according to any one of claims 1 to 6, wherein the housing is a conductive housing.

14. The electronic device according to any one of claims 1 to 6, wherein the non-display area is located on an edge of the screen assembly.
